(19) **Europäisches Patentamt / European Patent Office / Office européen des brevets**

(11) **EP 1 758 254 A1**

(12) **EUROPEAN PATENT APPLICATION**

(43) Date of publication:
28.02.2007 Bulletin 2007/09

(51) Int Cl.:
*H03M 13/27* *(2006.01)*      *H04N 7/66* *(2006.01)*
*H04L 1/00* *(2006.01)*

(21) Application number: 05300686.2

(22) Date of filing: 23.08.2005

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(71) Applicant: **Thomson Licensing**
**92100 Boulogne-Billancourt (FR)**

(72) Inventors:
• **Ma, Xiao Jun**
**Rm 03-09, 8F, Building A**
**Hai Dian District**
**100085 Beijing (CN)**

• **Wang, Charles**
**Rm 03-09, 8F, Building A**
**Hai Dian District**
**100085 Beijing (CN)**

(74) Representative: **Rossmanith, Manfred**
**Deutsche Thomson-Brandt GmbH**
**European Patent Operations**
**Karl-Wiechert-Allee 74**
**30625 Hannover (DE)**

(54) **Improved erasure correction scheme based on XOR operations for packet transmission**

(57) A system and method for XOR Based FEC are proposed. In order to achieve better capacity of recovering packet loss and keep the simplicity of XOR operation, the proposed FEC presents a strategy to generate as many redundant FEC packets as needed by grouping all packets in a matrix according to various predetermined rules. An FEC packet is generated for each group. The FEC applies XOR operation instead of RS codes to protect IP or higher level packets which facilitates software implementation.

Start

Determine if a complete matrix of media packets have been buffered — 410

Group all packets in the matrix according to predetermined rules, if needed, for instance, vertical, horizontal, zigzag, diagonal and so on — 420

As to each group, determine the length of the longest media packet, padding the remaining media packets to the same length with predefined bit pattern — 430

Generate a FEC packet for each group. The generated FEC packet should contain the type of predetermined rules from which the decoder can determine which group of media packets the FEC packet is associated with — 440

Transmit both media and FEC packets to target system — 450

End

Fig. 4

EP 1 758 254 A1

**Description**

FIELD OF THE INVENTION

The present invention relates generally to network reliability, and more particularly to multimedia communication system for correcting erasure errors in packet lossy networks.

BACKGROUND OF THE INVENTION

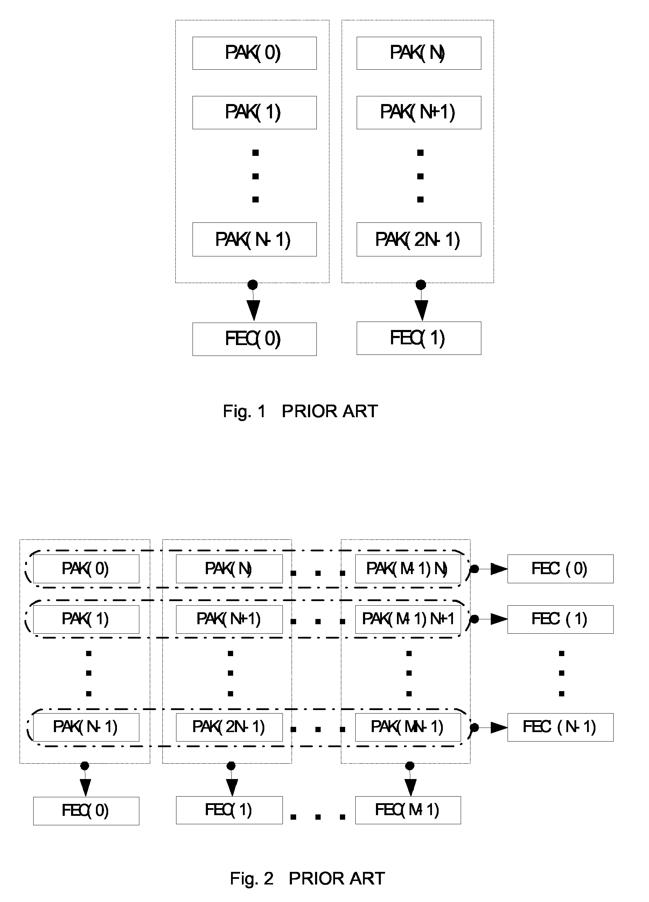

RFC 2733 [Rosenberg, J. and H. Schulzrinne, "An RTP Payload Format for Generic Forward Error Correction (referred as FEC hereafter)", RFC 2733, December 1999] presented an RTP payload format for Generic FEC against packet losses, while its extension version, uneven protection level, i.e. ULP, (Li, A., et. al., "An RTP Payload Format for Generic FEC with Uneven Level Protection", Internet draft, available from http://bgp.potaroo.net/ietf/all-ids/draft-ietf-avt-ulp-06.txt), was proposed to provide different protection levels for different data stream parts in terms of their different importance. Both RFC 2733 and ULP are based on an exclusive-or (XOR) operation. Figure 1 shows the basic idea of the above two solutions.

As shown in Figure 1, N data packets are grouped into an FEC block and XOR operations are performed over those N data packets. Obviously, since only one FEC packet can be generated for each block of N data packets, only one lost packet can be recovered if all other N data packets, including the generated FEC packet, were received correctly. This XOR-based FEC fails to recover lost packets if two or more packets of the block get lost.

To improve XOR-based FEC capacity, Peter Elmer (Peter Elmer, on behalf of WAN WG, "Transmission of Professional MPEG-2 transport streams over IP networks", available from http://www.pro-mpeg.org/publicdocs/pdf/ Vid-on-IP-CoP3-issue1.pdf) suggested generating FEC packets in two dimensions, shown in Figure 2. In this solution, two lost packets in one row or column can be recovered as long as other needed packets in the same row and column were received correctly.

However, in some cases, for instance, in a wireless channel, it is well known that the channel exhibits not only high bit error rate, but also due to its intrinsic characteristic of burst errors, consecutive packet loss occurs very often. As a result of the burst error, the additional FEC packets generated (the right-most column in Figure 2) play a very limited role to recover the lost packets.

Reed-Solomon (RS) code is such an algorithm that may be used to recover multiple missing packets in a grouped protected media packet block, such as disclosed in "Unequal and interleaved FEC protocol for robust MPEG-4 multicasting over wireless LANs" (Abdelhamid Nafaa, Toufik Ahmed, Ahmed Mehaoua, ICC 2004 - IEEE International Conference on Communications, vol. 27, no. 1, June 2004, referred as D4 hereafter) and "Adaptive forward error correction for real-time internet video" . (Johanson M., In: Proc. of the 13th Packet Video Workshop 2003, referred as D5 hereafter). Unequally Interleaved Forward Error Correction (UI-FEC), as disclosed in D4, provided interleaved protection scheme based on adaptive MPEG-4 video fragmentation to combat burst packet loss. D5 suggested an optimal packetization strategy relying on the loss rate measured by the receiver for error corrected video communication.

Above mentioned two RS based schemes, however, requires operations in finite field and high cost computation, which in turn leads to impracticability on resource-scarce devices such as PDA. Nevertheless, to deploy software based RS-FEC scheme is inapplicable since RS codes encoding/decoding are too computational intensive whereas multimedia applications have rather strict delay limitation.

A known forward error correction method and system is disclosed in US6851084 (referred as D6). D6 proposed a FEC solution by generating four parity packets from a group of four consecutive data packets where the four data packets form a 2 X 2 matrix. First, D6 only targets a fixed four packet group. Therefore, it could not recover all the missing packets in wireless network due to the error burst characteristic of wireless channel, which could introduce consecutive (more than four) packet loss. Moreover, as disclosed in D6, all packets in the group are treated with the same priority. In other words, the solution proposed by D6 could not treat packets with different priorities according to their importance.

A XOR based FEC method for loss recovery of packets over a compute network is disclosed in US6000053 (referred as D7 hereafter). As disclosed in D7, within a group one missing packet can be reconstructed as long as other data packets and the parity are received correctly. However, D7 does not teach how to recover two or more packet loss.

Another known forward error correction system for packet based real time transmission is disclosed in US5870412 (referred as D8 hereafter). As disclosed in D8, the parity packets and data packets are highly dependent on each other and some packet losses could introduce unexpected recovery time, which as discussed previously could not meet the strict delay limitation of multimedia applications. Furthermore, as disclosed in D8, same amount of redundant parity packets as data packets are always generated, which will definitely consume double network bandwidth.

Therefore, it is desirable to have such a solution, which could treat packets in differentiated manners according to their importance. Namely, a special policy could be defined for some more important data in order to protect them during transmission via packet lossy networks.

It is further desirable to have a solution, which is scalable, in other words, the size of group is not fixed and could be differentiated in order to generate as much redundancy as desired for meeting various needs.

SUMMARY OF THE INVENTION

In our proposed solution we devide data packet sequence into a series of group, and the parity packets are generated from the packets within the group. The missing packets can be recovered provided the needed data packets and corresponding parity packets are received, keeping the delay of error correction below expected upper limit.

Furthermore, our solution is more flexible than existing solution. The amount of redundant parity packets in our solution can be turned to meet the changing network conditions,

FEC is one key solution to cope with packet loss in error-prone network environments such as wireless and satellite networks. In contrast to RS (Reed-Solomon) code, XOR (exclusive-OR) based FEC has the advantage of computational low-cost and suits software implementation. However, existing XOR FEC solutions have very limited capability to recover lost packets, that is, only one or two packet losses can be recovered when all other packets within the protected group were received correctly. Therefore, more powerful FEC scheme is needed to recover multiple packet losses when network environment gets deteriorating. The proposed FEC can make applications more robust to packet losses and more resilient to various network conditions.

A transmitting method is proposed. The method for reliable transmitting a plurality of media packets from a transmitting system to a target system, the transmitting system and the target system coupled to each other via a network, the method including the steps of: determining if a complete matrix of media packets have been buffered; grouping the media packets in the matrix according to a plurality of predetermined rules, wherein the plurality of predetermined rules is selected from a set of predetermined rules $F = \{ f_k \}$, $k = 0,1, \ldots$ , where $f_k$ is a mapping from $G_k$ to $P$

$$f_k : \quad G_k \rightarrow P$$

or

$$f_k : \quad \left\{ \ g_n^k \ \right\} \rightarrow \quad \left\{ \ p_{i,j} \quad \right\}$$

where $0 \leq n < N_k$ , $0 \leq i < M$, and

$0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ p_{i,j} \}$ $(0 \leq i < M, 0 \leq j < N)$,

where $P$ be divided into $U$ groups: $P = \{ G_0, G_1, \ldots, G_{U-1} \}$ where $G_k$ $(0 \leq k < U)$ is a group and $G_k = \left\{ \ g_n^k \ \right\}$ where $n=0,1,\ldots, N_k$ and $N_k$ is the number of elements included by group $G_k$;

determining the length of the longest media packet in each group;

padding the remaining media packets in each group to the same length with a predefined bit pattern, wherein the predefined bit pattern includes '0' bits or '1' bits;

generating a FEC packet for each group using an "XOR" operation on the group members of each group, wherein the generated FEC packet should contain the information from which the target system is able to know which group of media packets the FEC packet is associated with; and

transmitting both the media packets and the FEC packets to the target system.

According to the present invention, the plurality of predetermined rules could be any one or any possible combination of the followings:

$$f_k \ (k=0,1,\ldots,M-1): \quad G_k \rightarrow P \quad \text{with} \quad g_n^k = f_k(p_{k,n}) \quad \text{where}$$

$$0 \leq n < N \ ;$$

$$f_k \ (k=0,1,\dots,N-1): \quad G_k \ \rightarrow \ P \quad \text{with} \quad g_n^k \ = \ f_k(p_{n,k}) \quad \text{where}$$

$$0 \leqq n < M \ ;$$

$$f_k \ (k=0,1,\dots,N-1): \quad G_k \ \rightarrow \ P \quad \text{with} \quad g_n^k \ = \ f_k(p_{n,(k+n) \bmod M})$$

where $0 \leqq n < M$ .

According to the present invention, the plurality of media packets include video packets, audio packets and other multimedia packets.

According to the present invention, the plurality of media packets are interleaved.

A transmitting system is proposed. The transmitting system used in association with a target system for reliable transmitting a plurality of media packets from the transmitting system to the target system, wherein said transmitting system coupled to said target system via a network, said transmitting system comprising: a FEC encoder configured to determine if a complete matrix of media packets have been buffered, also configured to group the media packets in the matrix according to a plurality of predetermined rules, wherein the plurality of predetermined rules is selected from a set of predetermined rules $F = \{ f_k \}$, $k = 0, 1, \dots$ ,

where $f_k$ is a mapping from $G_k$ to $P$

$f_k : G_k \rightarrow P$

or

$$f_k : \ \left\{ \ g_n^k \ \right\} \rightarrow \ \left\{ \ p_{i,j} \ \right\} \ \text{where} \ 0 \leqq n < N_k, \ 0 \leqq i < M, \text{ and}$$

$0 \leqq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ P_{i,j} \}$ $(0 \leqq i < M, 0 \leqq j < N)$ ,

where $P$ be divided into $U$ groups: $P = \{ G_0, G_1, \dots, G_{U-1} \}$ where $G_k$ $(0 \leqq k < U)$ is a group and $G_k = \ \left\{ \ g_n^k \ \right\}$ where $n = 0, 1, \dots, N_k$ and $N_k$ is the number of elements included by group $G_k$,

also configured to determine the length of the longest media packet in each group,

also configured to pad the remaining media packets in each group to the same length with a predefined bit pattern, wherein the predefined bit pattern includes '0' bits or '1' bits, and

configured to generate a FEC packet for each group using an "XOR" operation on the group members of each group, wherein the generated FEC packet should contain the information from which the target system is able to know which group of media packets the FEC packet is associated with; and

a packet transmitter configured to transmit the plurality of media packets and the FEC packets to the target system.

According to the present invention, the plurality of predetermined rules could be any one or any possible combination of the followings:

$$f_k \ (k=0,1,\dots,M-1): \quad G_k \ \rightarrow \ P \quad \text{with} \quad g_n^k \ = \ f_k(p_{k,n}) \quad \text{where}$$

$$0 \leqq n < N \ ;$$

$$f_k \ (k=0,1,\dots,N-1): \quad G_k \ \rightarrow \ P \quad \text{with} \quad g_n^k \ = \ f_k(p_{n,k}) \quad \text{where}$$

$$0 \leqq n < M \ ;$$

$$f_k \ (k=0,1,\ldots,N-1): \quad G_k \ \rightarrow \ P \quad \text{with} \quad g_n^k \ = \ f_k(p_{n,(k+n)\bmod M})$$

where $0 \leq n < M$ .

According to the present invention, the plurality of media packets include video packets, audio packets and other multimedia packets.

According to the present invention, the plurality of media packets are interleaved.

A recovering method is proposed. The method for recovering at least one lost or corrupt media packet, wherein said at least one lost or corrupt media packet is part of a plurality of media packets transmitted from a transmitting system to a target system, the transmitting system and the target system coupled to each other via a network, the method including the steps of: receiving media packets and FEC packets, and buffering the media packets to a matrix; determining if all media packets and FEC packets associated with the matrix, except the lost ones, have been received; determining the missing media packets belong to which groups according to a plurality of predetermined rules, wherein the plurality of predetermined rules is selected from a set of predetermined rules $F = \{ f_k \}$, $k = 0,1, \ldots ,$

where $f_k$ is a mapping from $G_k$ to $P$

$$f_k : G_k \rightarrow P$$

or

$$f_k : \ \left\{ \ g_n^k \ \right\} \rightarrow \ \left\{ \ p_{i,j} \ \right\} \quad \text{where } 0 \leq n < N_k, \ 0 \leq i < M, \text{ and}$$

$0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ p_{i,j} \}$ $(0 \leq i < M, 0 \leq j < N)$,

where $P$ be divided into $U$ groups: $P = \{ G_0, G_1, ..., G_{U-1} \}$ where $G_k$ $(0 \leq k < U)$ is a group and $G_k = \ \left\{ \ g_n^k \ \right\}$ where

$n = 0,1,...,N_k$ and $N_k$ is the number of elements included by group $G_k$;

padding all the media packets shorter than the longest one in the same group to the same length with a predefined bit pattern, wherein the predefined bit pattern includes '0' bits or '1' bits; and

reconstructing the missing media packets with received media packets and associated FEC packets by using "XOR" operation on the group members of each group until no further missing media packets can be recovered.

According to the present invention, the plurality of predetermined rules could be any one or any possible combination of the followings:

$$f_k \ (k=0,1,\ldots,M-1): \quad G_k \ \rightarrow \ P \quad \text{with} \quad g_n^k \ = \ f_k(p_{k,n}) \quad \text{where}$$

$0 \leq n < N$ ;

$$f_k \ (k=0,1,\ldots,N-1): \quad G_k \ \rightarrow \ P \quad \text{with} \quad g_n^k \ = \ f_k(p_{n,k}) \quad \text{where}$$

$0 \leq n < M$ ;

$$f_k \ (k=0,1,\ldots,N-1): \quad G_k \ \rightarrow \ P \quad \text{with} \quad g_n^k \ = \ f_k(p_{n,(k+n)\bmod M})$$

where $0 \leq n < M$ .

According to the present invention, the plurality of media packets include video packets, audio packets and other multimedia packets.

According to the present invention, the plurality of media packets are interleaved.

A target system used in association with a transmitting system for reliable transmitting a plurality of media packets from the transmitting system to the target system, wherein said transmitting system coupled to said target system via a network is proposed. The target system comprising: a packet receiver configured to receive the media packets and FEC packets, to buffer the media packets to a matrix, and configured to determine if all media packets and FEC packets associated with the matrix, except the lost ones, have been received; a packet loss detector configured to detect if some of the media packets have been lost, and configured to determine the missing media packets belong to which groups according to a plurality of predetermined rules, wherein the plurality of predetermined rules is selected from a set of predetermined rules $F = \{ f_k \}$, $k = 0,1, ...$ ,

where $f_k$ is a mapping from $G_k$ to $P$

$$f_k : G_k \rightarrow P$$

or

$$f_k : \left\{ g_n^k \right\} \rightarrow \left\{ p_{i,j} \right\}$$ where $0 \leq n < N_k$, $0 \leq i < M$, and $0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ p_{i,j} \}$ $(0 \leq i < M, 0 \leq j < N)$ ,

where $P$ be divided into $U$ groups: $P = \{ G_0, G_1, ..., G_{U-1} \}$ where $G_k$ $(0 \leq k < U)$ is a group and $G_k = \left\{ g_n^k \right\}$ where $n = 0,1,..., N_k$ and $N_k$ is the number of elements included by group $G_k$; and

a packet reconstructor configured to pad all the media packets shorter than the longest one in the same group to the same length with a predefined bit pattern, wherein the predefined bit pattern includes '0' bits or '1' bits, and configured to reconstruct the missing media packets using "XOR" operation on the group members of each group until no further missing media packets can be recovered.

According to the present invention, the plurality of predetermined rules could be any one or any possible combination of the followings:

$$f_k \ (k=0,1,...,M-1): \ G_k \ \rightarrow \ P \ \text{with} \ g_n^k \ = \ f_k(p_{k,n}) \ \text{where}$$

$$0 \leq n < N \ ;$$

$$f_k \ (k=0,1,...,N-1): \ G_k \ \rightarrow \ P \ \text{with} \ g_n^k \ = \ f_k(p_{n,k}) \ \text{where}$$

$$0 \leq n < M \ ;$$

$$f_k \ (k=0,1,...,N-1): \ G_k \ \rightarrow \ P \ \text{with} \ g_n^k \ = \ f_k(p_{n,(k+n) \bmod M})$$

$$\text{where} \ 0 \leq n < M \ .$$

According to the present invention, the plurality of media packets include video packets, audio packets and other multimedia packets.

According to the present invention, the plurality of media packets are interleaved.

<u>BRIEF DESCRIPTION OF THE DRAWINGS</u>

Fig. 1 is a schematic diagram showing the FEC proposed by RFC 2733 and its extension;

Fig. 2 is a schematic diagram showing the FEC proposed by Peter Elmer;

Fig. 3 is a schematic diagram showing some rules of how to generate FEC packets according to the present invention;

Fig. 4 is a flow chart showing the transmitting method according to the present invention;

Fig. 5 is a flow chart showing the recovering method according to the present invention;

Fig. 6 is a schematic diagram illustrating the operation at the transmitting system side according to the present invention;

Fig. 7 is a schematic diagram illustrating the operation at the target system side according to the present invention;

Fig. 8 is a schematic diagram showing a matrix of media packets protected by row and column FEC parity according to the present invention;

Fig. 9 is a schematic diagram showing four lost packets $P_0$, $P_1$, $P_n$ and $P_{n+1}$ in the matrix; and

Fig. 10 is a schematic diagram showing a diagonal FEC defined according to the present invention.

## DETAILED DESCRIPTION OF THE PREFERRED EMBODIMENTS

The technical features of the present invention will be described further with reference to the embodiments. The embodiments are only preferable examples without limiting to the present invention. It will be well understood by the following detail description in conjunction with the accompanying drawings.

The idea behind our proposed FEC is to generate as more XOR-based FEC packets as needed according to various defined rules so as to be more powerful in error correction.

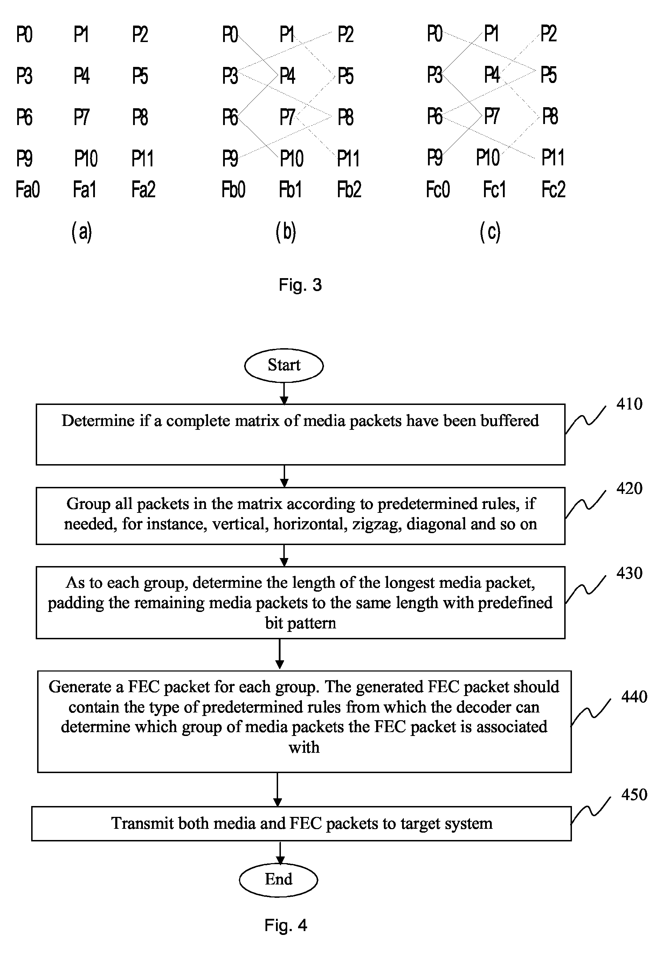

We generate FEC packets in two steps as follows. An example is shown in Figure 3. Let Pi (i = 1,2,...) be a sequence of media packets, and all Pis are composed into one matrix.

First, group all media packets in the matrix according to their sequence numbers. Note that various rules can be defined to group media packets. For instance, in Figure 3(a) let all media packets with sequence number of 3*n in group 1, 3*n+1 in group 2, and 3*n+2 in group 3, respectively, where n=0, 1, .... We also can group media packets in a zigzag or some other manners, for example, as shown in Figure 3(b) let P0, P4, P6, P10 in group 1, and P1, P5, P7, P11 in group 2, P2, P3, P8, P9 in group 3.

Second, generates one FEC packet for each one group by applying XOR operation. For example, in Figure 3 FEC packet Fa0 is the result of applying XOR across media packet P0, P3, P6 and P9. Fb0 is the result of applying XOR across media packet P0, P4, P6 and P10, and so on.

Above we have presented the strategy to generate as more FEC packets as needed. It is obvious that the more FEC packets we send out the more lost media packets can be recovered. However, sending out more FEC packets means more overhead bandwidth is needed for transmitting redundant information.

In order to achieve better capacity of recovering packet loss and keep the simplicity of XOR operation, the proposed FEC presents a strategy to generate as more redundant FEC packets as needed by applying various rules across a matrix of protected media packets. Meanwhile, the FEC applies XOR operation instead of RS codes to protect IP or higher level packets which facilitates software implementation.

As shown in Fig. 4, a transmitting method is illustrated. Step **410** is to determine if a complete matrix of media packets have been buffered. In order to facilitate the description, we use a matrix to buffer the media packets. A matrix, for example, with the size of m rows and n columns, is composed of m*n nodes. Every node in the matrix can be filled with one packet. Every media packet being transmitted should be buffered to a matrix. The transmitting system checks the matrix on-line to make sure whether the matrix has been completed. A complete matrix means every node in the matrix has been filled with a packet. In Step **420,** all packets are grouped in the matrix according to predetermined rules, if needed. The predetermined rules, for instance, could be vertical, horizontal, zigzag, diagonal and so on. As to each group, the length of the longest media packet is determined in Step **430,** and also padding the remaining media packets with predefined bit pattern in the same step. A FEC packet is generated for each group in Step **440.** The generated FEC packet should contain the information from which the target system is able to know which group of media packets the FEC packet is associated with. Both media and FEC packets are transmitted to target system in Step **450.**

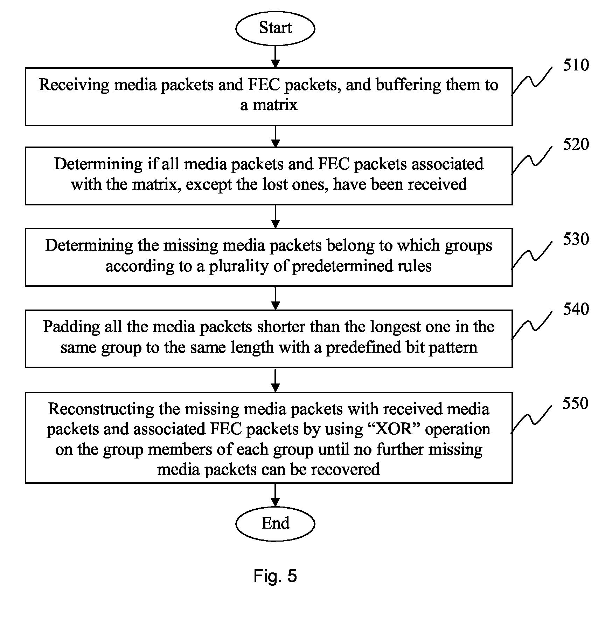

As shown in Fig. 5, a recovering method is illustrated. Step **510** is to receive media packets and FEC packets, and to buffer the media packets to a matrix. A matrix, for example, with the size of m rows and n columns, is composed of m*n nodes. Every node in the matrix can be filled with one media packet. Every received media packet should be buffered to a matrix. Step **520** is to determine if all media packets and FEC packets associated with the matrix, except the lost ones, have been received. A matrix can be denoted by two parameters, matrix base and matrix size. Every media packet contains a sequence number for the purpose of identifying itself. Matrix base is the sequence number of the first media packet belonging to the matrix. Matrix size is the size of the matrix, i.e., the number of nodes in the matrix, say, m*n. Since the packet sequence number can be obtained from each packet, the target system is able to know whether the received packets belong to the current matrix or the other.

The target system checks the matrix on-line to make sure whether all the media packets belonging to a matrix, has been received. We also assume that all packets are transmitted sequentially over the network. So once the last packet belonging to the current matrix or a packet belonging to next matrix was received, the target system knows the current matrix is ready for processing.

Step **530** is to determine the missing media packets belong to which groups according to a plurality of predetermined rules. For each group, if and only if one media packet of them was lost and the associated FEC was received, the missing media packet can be reconstructed. Before reconstructing a missing packet, all the media packets should be padded with a predefined bit pattern to match the length of the longest media packet in the group. A predefined bit pattern includes '0' bits or '1' bits. Packet padding is performed in step **540.**

Step **550** is to reconstruct missing media packets by using "XOR" operation on the group members of each group until no further missing media packets can be recovered. A media packet may be included in several different groups according to the predetermined rules, for example, media packet P may be included in group 1 and group 2. In group 1, two media packets P, Q were lost and in group 2 packet P was lost. Both FEC packets associated to group 1 and group 2 were received. In this case, we first reconstruct packet P within group 2. After packet P was reconstructed, we can reconstruct packet Q within group 1 since packet P was reconstructed before.

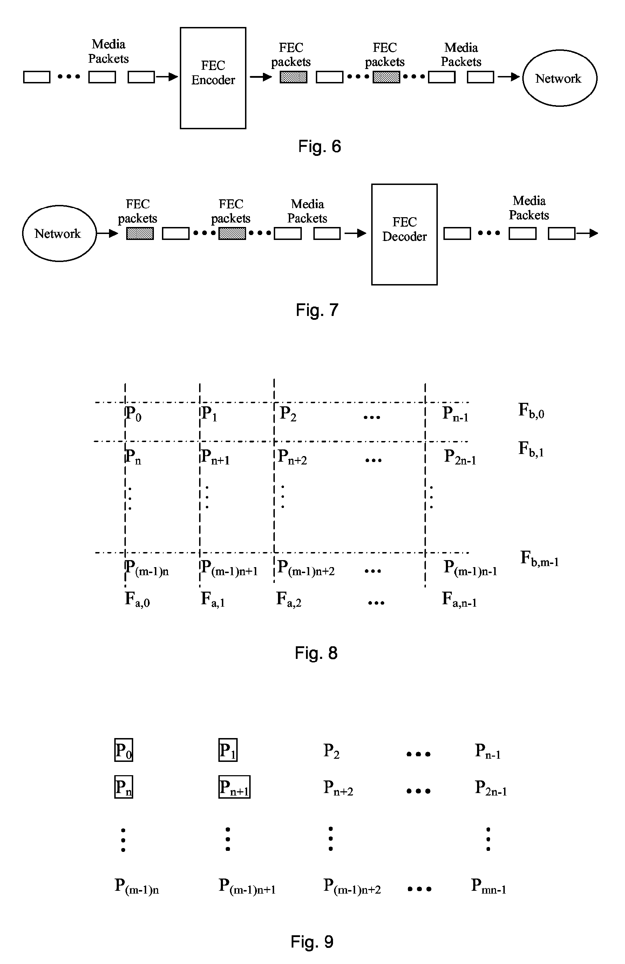

As shown in Fig. 6, on transmitting system side or media data sender side, the FEC encoder generates FEC packets by taking media packets feeds and sends out the media packets together with the generated FEC packets. On the target system side or the receiver side, as shown in Fig. 7, as long as a media packet got lost, the FEC decoder tries to recover the missing packet by using the received media packets and FEC packets as well.

Fig. 8 shows a matrix of media packets protected by row and column FEC parity according to one embodiment of the present invention. For simplicity, let $g(a, 0)$ denote the group containing media packet $P_0$, $P_n$ ... $P_{(m-1)n}$, $g(a, 1)$ denote the group containing media packet $P_1$, $P_{n+1}$ ... $P_{(m-1)n+1}$, and so on; let $g(b, 0)$ denote the group containing media packet $P_0$, $P_1$ ... $P_{n-1}$, $g(b, 1)$ denote the group containing media packet $P_n$, $P_{n+1}$ ... $P_{2n-1}$, and so on. Therefore, FEC packet $F_{a,0}$ is generated by applying XOR operation across the group $g(a, 0)$. FEC packet $F_{a,1}$ is generated by applying XOR operation across the group $g(a, 1)$, and so on. $F_{b,0}$ is generated by applying XOR operation across the group $g(b, 0)$. FEC packet $F_{b,1}$ is generated by applying XOR operation across the group $g(b, 1)$, and so on. Thus, any one and only one missing media packet within group $g(a, 0)$ can be reconstructed as long as remaining media packets in $g(a, 0)$ and FEC packet $F_{a,0}$ were received correctly.

However, suppose in the matrix all remaining media packets, except four packets $P_0$, $P_1$, $P_n$ and $P_{n+1}$, as shown in Fig. 9, were lost. Further, suppose all FEC packets associated with the matrix were received. It is obvious that all the four packets cannot be reconstructed since in $g(a, 0)$ two packets $P_0$ and $P_n$ were lost and neither of them can be recovered. The same situation also happens in $g(a, 1)$, $g(b, 0)$ and $g(b, 1)$.

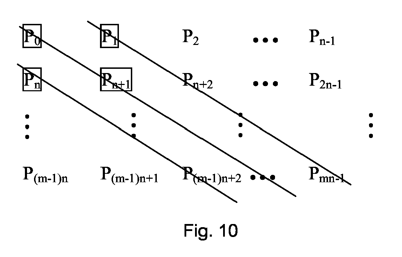

In order to increase the error correction capacity we can set up various predefined rules and generate more FEC packets. As shown in Fig. 10, a diagonal FEC protection is defined according to another embodiment of the present invention. To be simplicity, let group $g(c, 0)$ consists of Packet $P_0$, $P_{n+1}$, $P_{2n+2}$, ...; group $g(c, 1)$ consists of Packet $P_1$, $P_{n+2}$, $P_{2n+3}$, ...; group $g(c, 2)$ consists of Packet $P_n$, $P_{2n+1}$, $P_{3n+2}$, ... . Hereafter, in $g(c, 1)$ except $P_1$ as long as all remaining media packets were received, $P_1$ can be reconstructed. As a result, in $g(b, 0)$ $P_0$ can be reconstructed. Consequently, $P_n$ and $P_{n+1}$ can also be reconstructed.

Obviously the aforementioned diagonal FEC can increase error correction capacity. However, other rules, for example zigzag can also be defined to meet the requirements of increasing error correction capacity.

The present invention can be used by various applications targeting streaming multimedia over unreliable network, for instance, video streaming over wireless, satellite or DSL networks. IPTV is such a promising application that might also benefit from the present invention. With the computationally simple yet powerful scheme proposed by the present invention, the packet loss in multimedia communication is coped. The present invention is suitable for software implementation since it applies only XOR operation. It also achieves better flexibility of recovering multiple missing packets than existing XOR based FEC schemes.

Whilst there has been described in the forgoing description preferred embodiments and aspects of the present invention, it will be understood by those skilled in the art that many variations in details of design or construction may be made without departing from the present invention. The present invention extends to all features disclosed both individually, and in all possible permutations and combinations.

**Claims**

**1.** A method for reliable transmitting a plurality of media packets from a transmitting system to a target system, the transmitting system and the target system coupled to each other via a network, the method including the steps of:

determining if a complete matrix of media packets have been buffered;
grouping the media packets in the matrix according to a plurality of predetermined rules, wherein the plurality of predetermined rules is selected from a set of predetermined rules $F = \{ f_k \}$, $k = 0,1, \dots$ ,

where $f_k$ is a mapping from $G_k$ to $P$

$$f_k : G_k \rightarrow P$$

or

$$f_k : \{ g_n^k \} \rightarrow \{ p_{i,j} \}$$ where $0 \leq n < N_k$, $0 \leq i < M$, and $0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ p_{i,j} \}$ ($0 \leq i < M$, $0 \leq j < N$),

where $P$ be divided into $U$ groups: $P = \{ G_0, G_1, \dots, G_{U-1} \}$ where $G_k$ ($0 \leq k < U$) is a group and $G_k = \{ g_n^k \}$

where $n = 0,1,\dots, N_k$ and $N_k$ is the number of elements included by group $G_k$;
determining the length of the longest media packet in each group;
padding the remaining media packets in each group to the same length with a predefined bit pattern, wherein the predefined bit pattern includes '0' bits or '1' bits;
generating a FEC packet for each group using an "XOR" operation on the group members of each group, wherein the generated FEC packet should contain the information from which the target system is able to know which group of media packets the FEC packet is associated with; and
transmitting both the media packets and the FEC packets to the target system.

**2.** The method according to claim 1, wherein said plurality of predetermined rules could be any one or any possible combination of the followings:

$$f_k \ (k=0,1,\dots,M-1): \ G_k \ \rightarrow \ P \ \text{with} \ g_n^k \ = \ f_k(p_{k,n})$$

$$\text{where } 0 \leq n < N \text{ ;}$$

$$f_k \ (k=0,1,\dots,N-1): \ G_k \ \rightarrow \ P \ \text{with} \ g_n^k \ = \ f_k(p_{n,k})$$

$$\text{where } 0 \leq n < M \text{ ;}$$

$$f_k \ (k=0,1,\dots,N-1): \ G_k \rightarrow P \ \text{with} \ g_n^k \ = \ f_k(p_{n,(k+n) \bmod M})$$

$$\text{where } 0 \leq n < M \text{ .}$$

**3.** The method according to claim 1, wherein said plurality of media packets include video packets, audio packets and other multimedia packets.

**4.** The method according to claim 1, wherein said plurality of media packets are interleaved.

**5.** A transmitting system used in association with a target system for reliable transmitting a plurality of media packets from the transmitting system to the target system, wherein said transmitting system coupled to said target system via a network, said transmitting system comprising:

a FEC encoder configured to determine if a complete matrix of media packets have been buffered,
also configured to group the media packets in the matrix according to a plurality of predetermined rules, wherein the plurality of predetermined rules is selected from a set of predetermined rules $F = \{ f_k \}$, $k = 0,1, \dots$ ,

where $f_k$ is a mapping from $G_k$ to $P$

$f_k : G_k \rightarrow P$

or

$$f_k : \left\{ g_n^k \right\} \rightarrow \left\{ p_{i,j} \right\}$$ where $0 \leqq n < N_k$, $0 \leqq i < M$, and $0 \leqq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P= \{ p_{i,j} \}$ $(0 \leqq i < M, 0 \leqq j < N)$,

where $P$ be divided into $U$ groups: $P = \{ G_0, G_1, ..., G_{U-1} \}$ where $G_k$ $(0 \leqq k < U)$ is a group and $G_k = \left\{ g_n^k \right\}$ where $n=0,1,..., N_k$ and $N_k$ is the number of elements included by group $G_k$,

also configured to determine the length of the longest media packet in each group,

also configured to pad the remaining media packets in each group to the same length with a predefined bit pattern, wherein the predefined bit pattern includes '0' bits or '1' bits, and

configured to generate a FEC packet for each group using an "XOR" operation on the group members of each group, wherein the generated FEC packet should contain the information from which the target system is able to know which group of media packets the FEC packet is associated with; and

a packet transmitter configured to transmit the plurality of media packets and the FEC packets to the target system.

**6.** The transmitting system according to claim 5, wherein said plurality of predetermined rules could be any one or any possible combination of the followings:

$$f_k \ (k=0,1,…,M-1): \quad G_k \ \rightarrow \ P \quad \text{with} \quad g_n^k \ = \ f_k (p_{k,n})$$

where $0 \leqq n < N$ ;

$$f_k \ (k=0,1,…,N-1): \quad G_k \ \rightarrow \ P \quad \text{with} \quad g_n^k \ = \ f_k (p_{n,k})$$

where $0 \leqq n < M$ ;

$$f_k \ (k=0,1,…,N-1): \quad G_k \rightarrow P \quad \text{with} \quad g_n^k \ = \ f_k (p_{n,(k+n) \bmod M})$$

where $0 \leqq n < M$ .

**7.** The transmitting system according to claim 5, wherein said plurality of media packets include video packets, audio packets and other multimedia packets.

**8.** The transmitting system according to claim 5, wherein said plurality of media packets are interleaved.

**9.** A method for recovering at least one lost or corrupt media packet, wherein said at least one lost or corrupt media packet is part of a plurality of media packets transmitted from a transmitting system to a target system, the transmitting system and the target system coupled to each other via a network, the method including the steps of:

receiving media packets and FEC packets, and buffering the media packets to a matrix;

determining if all media packets and FEC packets associated with the matrix, except the lost ones, have been received;

determining the missing media packets belong to which groups according to a plurality of predetermined rules, wherein the plurality of predetermined rules is selected from a set of predetermined rules $F= \{ f_k \}$, $k = 0,1, ... ,$

where $f_k$ is a mapping from $G_k$ to $P$

$f_k : G_k \rightarrow P$

or

$$f_k : \left\{ \ g_n^k \ \right\} \rightarrow \left\{ \ p_{i,j} \ \right\}$$ where $0 \leq n < N_k$, $0 \leq i < M$, and $0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ p_{i,j} \}$ $(0 \leq i < M, 0 \leq j < N)$,

where $P$ be divided into $U$ groups: $P = \{ G_0, G_1, ..., G_{U-1} \}$ where $G_k$ $0 \leq k < U$) is a group and $$G_k = \left\{ \ g_n^k \ \right\}$$

where $n = 0, 1, ..., N_k$ and $N_k$ s the number of elements included by group $G_k$;

padding all the media packets shorter than the longest one in the same group to the same length with a predefined bit pattern, wherein the predefined bit pattern includes '0' bits or '1' bits; and

reconstructing the missing media packets with received media packets and associated FEC packets by using "XOR" operation on the group members of each group until no further missing media packets can be recovered.

**10.** The method according to claim 9, wherein said plurality of predetermined rules could be any one or any possible combination of the followings:

$$f_k \ (k=0,1,\ldots,M-1): \quad G_k \ \rightarrow \ P \quad \text{with} \quad g_n^k \ = \ f_k(p_{k,n})$$

$$\text{where } 0 \leq n < N \ ;$$

$$f_k \ (k=0,1,\ldots,N-1): \quad G_k \ \rightarrow \ P \quad \text{with} \quad g_n^k \ = \ f_k(p_{n,k})$$

$$\text{where } 0 \leq n < M \ ;$$

$$f_k \ (k=0,1,\ldots,N-1): \quad G_k \rightarrow P \quad \text{with} \quad g_n^k \ = \ f_k(p_{n,(k+n) \bmod M})$$

$$\text{where } 0 \leq n < M \ .$$

**10.** The method according to claim 9, wherein said plurality of media packets include video packets, audio packets and other multimedia packets.

**11.** The method according to claim 9, wherein said plurality of media packets are interleaved.

**12.** A target system used in association with a transmitting system for reliable transmitting a plurality of media packets from the transmitting system to the target system, wherein said transmitting system coupled to said target system via a network, said target system comprising:

a packet receiver configured to receive the media packets and FEC packets, to buffer the media packets to a matrix, and configured to determine if all media packets and FEC packets associated with the matrix, except the lost ones, have been received;

a packet loss detector configured to detect if some of the media packets have been lost, and configured to determine the missing media packets belong to which groups according to a plurality of predetermined rules, wherein the plurality of predetermined rules is selected from a set of predetermined rules $F = \{ f_k \}$, $k = 0,1, ... ,$

where $f_k$ is a mapping from $G_k$ to $P$

$f_k : G_k \rightarrow P$

or

$$f_k \; : \; \left\{ \; g_n^k \; \right\} \to \; \left\{ \; p_{i,j} \; \right\}$$ where $0 \leq n < N_k$, $0 \leq i < M$, and $0 \leq j < N$, $f_k$ defines a regulation of how to select the nodes $p_{i,j}$ from matrix $P$ to form a group $G_k$,

where $p_{i,j}$ is a node in a matrix $P$ consisting of $M*N$ nodes, denoted as $P = \{ P_{i,j} \}$ $(0 \leq i < M, 0 \leq j < N)$,

where $P$ be divided into $U$ groups: $P = \{ G_0, G_1, ..., G_{U-1} \}$ where $G_k$ $(0 \leq k < U)$ is a group and $G_k = \left\{ \; g_n^k \; \right\}$ where $n = 0, 1, ..., N_k$ and $N_k$ is the number of elements included by group $G_k$; and

a packet reconstructor configured to pad all the media packets shorter than the longest one in the same group to the same length with a predefined bit pattern, wherein the predefined bit pattern includes '0' bits or '1' bits, and configured to reconstruct the missing media packets using "XOR" operation on the group members of each group until no further missing media packets can be recovered.

**13.** The target system according to claim 12, wherein said plurality of predetermined rules could be any one or any possible combination of the followings:

$$f_k \; (k=0,1,…,M-1): \; G_k \; \to \; P \; \texttt{with} \; g_n^k \; = \; f_k(p_{k,n})$$

$$\texttt{where} \; 0 \leq n < N \; ;$$

$$f_k \; (k=0,1,…,N-1): \; G_k \; \to \; P \; \texttt{with} \; g_n^k \; = \; f_k(p_{n,k})$$

$$\texttt{where} \; 0 \leq n < M \; ;$$

;

$$f_k \; (k=0,1,…,N-1): \; G_k \to P \; \texttt{with} \; g_n^k \; = \; f_k(p_{n,(k+n) \bmod M})$$

$$\texttt{where} \; 0 \leq n < M \; .$$

**14.** The target system according to claim 12, wherein said plurality of media packets include video packets, audio packets and other multimedia packets.

**15.** The target system according to claim 12, wherein said plurality of media packets are interleaved.

| | |
|---|---|
| PAK( 0) | PAK( N) |
| PAK( 1) | PAK( N+1) |
| . | . |
| PAK( N- 1) | PAK( 2N- 1) |
| FEC( 0) | FEC( 1) |

Fig. 1   PRIOR ART

| PAK( 0) | PAK( N) | . . . | PAK( M- 1) N) | FEC ( 0) |
|---|---|---|---|---|
| PAK( 1) | PAK( N+1) | . . . | PAK( M- 1) N+1 | FEC ( 1) |
| . | . | | . | . |
| PAK( N- 1) | PAK( 2N- 1) | . . . | PAK( MN- 1) | FEC ( N- 1) |
| FEC( 0) | FEC( 1) | . . . | FEC( M- 1) | |

Fig. 2   PRIOR ART

| | | | | | | | | |
|---|---|---|---|---|---|---|---|---|
| P0 | P1 | P2 | P0 | P1 | P2 | P0 | P1 | P2 |
| P3 | P4 | P5 | P3 | P4 | P5 | P3 | P4 | P5 |
| P6 | P7 | P8 | P6 | P7 | P8 | P6 | P7 | P8 |
| P9 | P10 | P11 | P9 | P10 | P11 | P9 | P10 | P11 |
| Fa0 | Fa1 | Fa2 | Fb0 | Fb1 | Fb2 | Fc0 | Fc1 | Fc2 |
| (a) | | | (b) | | | (c) | | |

Fig. 3

Start

Determine if a complete matrix of media packets have been buffered — 410

Group all packets in the matrix according to predetermined rules, if needed, for instance, vertical, horizontal, zigzag, diagonal and so on — 420

As to each group, determine the length of the longest media packet, padding the remaining media packets to the same length with predefined bit pattern — 430

Generate a FEC packet for each group. The generated FEC packet should contain the type of predetermined rules from which the decoder can determine which group of media packets the FEC packet is associated with — 440

Transmit both media and FEC packets to target system — 450

End

Fig. 4

Start

Receiving media packets and FEC packets, and buffering them to a matrix — 510

Determining if all media packets and FEC packets associated with the matrix, except the lost ones, have been received — 520

Determining the missing media packets belong to which groups according to a plurality of predetermined rules — 530

Padding all the media packets shorter than the longest one in the same group to the same length with a predefined bit pattern — 540

Reconstructing the missing media packets with received media packets and associated FEC packets by using "XOR" operation on the group members of each group until no further missing media packets can be recovered — 550

End

Fig. 5

Fig. 6

Fig. 7

Fig. 8

Fig. 9

$P_0$   $P_1$   $P_2$   $\bullet\bullet\bullet$   $P_{n-1}$

$P_n$   $P_{n+1}$   $P_{n+2}$   $\bullet\bullet\bullet$   $P_{2n-1}$

$P_{(m-1)n}$   $P_{(m-1)n+1}$   $P_{(m-1)n+2}$   $\bullet\bullet\bullet$   $P_{mn-1}$

Fig. 10

**European Patent Office**

# EUROPEAN SEARCH REPORT

Application Number

EP 05 30 0686

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 271 830 A (MICROSOFT CORPORATION) 2 January 2003 (2003-01-02) * figures 6,7 * * paragraphs [0003], [0058] * * paragraph [0065] - paragraph [0070] * | 1-15 | H03M13/27 H04N7/66 H04L1/00 |
| | ----- | | |
| X | WAN GROUP: "Transmission of Professional MPEG-2 Transport Streams over IP Networks"[Online] 26 July 2004 (2004-07-26), pages 1-17, XP002361396 Retrieved from the Internet: URL:http://www.pro-mpeg.org/publications/p df/Vid-on-IP-CoP3-r2.pdf> [retrieved on 2006-01-02] * page 5 - page 7 * * page 9 - page 10 * | 1-15 | |
| | ----- | | |
| D,X | ROSENBERG J ET AL: "An RTP Payload Format for Generic Forward Error Correction" IETF STANDARD, INTERNET ENGINEERING TASK FORCE, IETF, CH, no. RFC2733, December 1999 (1999-12), XP015008516 ISSN: 0000-0003 * page 3 - page 6 * * page 9 - page 10 * | 1,3-5, 7-12,14, 15 | TECHNICAL FIELDS SEARCHED (IPC)  H03M H04N H04L |
| | ----- | | |
| X | US 2003/002502 A1 (GIBSON WILLIAM A ET AL) 2 January 2003 (2003-01-02)  * abstract * * figures 2,6b-e,14 * * paragraph [0001] * * paragraph [0009] - paragraph [0011] * * paragraphs [0045], [0057] * | 1,3-5, 7-12,14, 15 | |
| | ----- | | |
| | -/-- | | |

The present search report has been drawn up for all claims

| Place of search | Date of completion of the search | Examiner |
|---|---|---|
| Munich | 3 January 2006 | Offer, E |

EPO FORM 1503 03.82 (P04C01)

**European Patent Office**

**EUROPEAN SEARCH REPORT**

Application Number

EP 05 30 0686

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,Y | US 2003/229840 A1 (PATTAVINA JEFFREY S) 11 December 2003 (2003-12-11) * the whole document * ----- | 1-15 | |
| Y | US 6 421 805 B1 (MCAULIFFE RICHARD) 16 July 2002 (2002-07-16) * figure 3 * * column 4, line 39 - line 52 * ----- | 1-15 | |
| Y | SAKAMOTO T ET AL: "A study of ECG telemonitoring system using mobile internet connections" PROC., IEEE INTERNATIONAL CONFERENCE ONCOMPUTER AND INFORMATION TECHNOLOGY, CIT '04, 14 September 2004 (2004-09-14), pages 593-597, XP010743102 ISBN: 0-7695-2216-5 * the whole document * ----- | 1-15 | |
| Y | US 6 000 053 A (LEVINE ET AL) 7 December 1999 (1999-12-07) * the whole document * ----- | 1-15 | TECHNICAL FIELDS SEARCHED (IPC) |
| A | US 6 243 846 B1 (SCHUSTER GUIDO M ET AL) 5 June 2001 (2001-06-05) * abstract * * column 5, line 44 - column 7, line 39 * * column 9, line 20 - line 28 * ----- | 1-15 | |
| A | SHACHAM N: "Packet recovery and error correction in high-speed wide-area networks" PROC., IEEE MILITARY COMMUNICATIONS CONFERENCE, MILCOM'89, BOSTON, US, 15 October 1989 (1989-10-15), pages 551-557, XP010083508 * the whole document * ----- | 1-15 | |

-/--

The present search report has been drawn up for all claims

| Place of search | Date of completion of the search | Examiner |
|---|---|---|
| Munich | 3 January 2006 | Offer, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

**European Patent Office**

**EUROPEAN SEARCH REPORT**

Application Number

EP 05 30 0686

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ALKHALIFA Z ET AL: "Linear codes for end to end cell loss recovery in VBR video transmission over ATM networks" ATM, 1999. ICATM '99. 1999 2ND INTERNATIONAL CONFERENCE ON COLMAR, FRANCE 21-23 JUNE 1999, PISCATAWAY, NJ, USA,IEEE, US, 21 June 1999 (1999-06-21), pages 512-520, XP010346218 ISBN: 0-7803-5428-1 * the whole document * | 1-15 | |
| A | KALATHUR R ET AL: "Forward error correction with buffer management in multimedia ATM networks" SOUTHCON /94. CONFERENCE RECORD. ORLANDO, MAR. 29 - 31, 1994, NEW YORK, IEEE, US, 29 March 1994 (1994-03-29), pages 437-444, XP010157996 ISBN: 0-7803-9989-7 * the whole document * | 1-15 | |

TECHNICAL FIELDS SEARCHED (IPC)

The present search report has been drawn up for all claims

| Place of search | Date of completion of the search | Examiner |
|---|---|---|
| Munich | 3 January 2006 | Offer, E |

EPO FORM 1503 03.82 (P04C01)

**EP 1 758 254 A1**

ANNEX TO THE EUROPEAN SEARCH REPORT
ON EUROPEAN PATENT APPLICATION NO.

EP 05 30 0686

This annex lists the patent family members relating to the patent documents cited in the above-mentioned European search report.
The members are as contained in the European Patent Office EDP file on
The European Patent Office is in no way liable for these particulars which are merely given for the purpose of information.

03-01-2006

| Patent document cited in search report | | | Publication date | Patent family member(s) | | | Publication date |
|---|---|---|---|---|---|---|---|
| EP 1271830 | | A | 02-01-2003 | JP<br>US | 2003092564<br>2003005386 | A<br>A1 | 28-03-2003<br>02-01-2003 |
| US 2003002502 | A1 | | 02-01-2003 | AU<br>US<br>WO | 3768099<br>6445717<br>9957829 | A<br>B1<br>A1 | 23-11-1999<br>03-09-2002<br>11-11-1999 |
| US 2003229840 | A1 | | 11-12-2003 | AU<br>EP<br>WO | 2003251388<br>1512228<br>03105349 | A1<br>A1<br>A1 | 22-12-2003<br>09-03-2005<br>18-12-2003 |
| US 6421805 | B1 | | 16-07-2002 | NONE | | | |
| US 6000053 | A | | 07-12-1999 | NONE | | | |
| US 6243846 | B1 | | 05-06-2001 | NONE | | | |

EPO FORM P0459

For more details about this annex : see Official Journal of the European Patent Office, No. 12/82

21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6851084 B
- US 6000053 A
- US 5870412 A

**Non-patent literature cited in the description**

- **ROSENBERG, J. ; H. SCHULZRINNE.** An RTP Payload Format for Generic Forward Error Correction (referred as FEC hereafter. *RFC 2733,* December 1999
- **LI, A.** *An RTP Payload Format for Generic FEC with Uneven Level Protection, http://bgp.potaroo.net/ietf/all-ids/draft-ietf-avt-ulp-06.txt*
- **PETER ELMER.** *Transmission of Professional MPEG-2 transport streams over IP networks, http://www.pro-mpeg.org/publicdocs/pdf/ Vid-on-IP-CoP3-issue1.pdf*
- **ABDELHAMID NAFAA ; TOUFIK AHMED ; AHMED MEHAOUA.** *ICC 2004 - IEEE International Conference on Communications,* June 2004, vol. 27 (1
- **JOHANSON M.** *Proc. of the 13th Packet Video Workshop,* 2003